# EUROPEAN PATENT SPECIFICATION

(11) **EP 4 246 569 B1**
(45) Date of publication and mention of the grant of the patent: **30.07.2025**
(21) Application number: 23162254.9
(22) Date of filing: 16.03.2023
(51) Int. Cl.: H01L 23/31, H01L 23/00, H10D 8/00, H10D 62/10, H01L 23/58

(54) **CHIP AND ELECTRONIC DEVICE**
CHIP UND ELEKTRONISCHE VORRICHTUNG
PUCE ET DISPOSITIF ÉLECTRONIQUE

(30) Priority: 17.03.2022 CN 202210262835
(43) Date of publication of application: 20.09.2023
(73) Proprietor: Huawei Digital Power Technologies Co., Ltd., Shenzhen, 518043 (CN)
(72) Inventor: TANG, Longgu, Shenzhen, 518043 (CN); HU, Fei, Shenzhen, 518043 (CN); GAO, Bo, Shenzhen, 518043 (CN); LIU, Chia Fu, Shenzhen, 518043 (CN); HUANG, Boning, Shenzhen, 518043 (CN); LIU, Zhihua, Shenzhen, 518043 (CN)
(74) Representative: Körber, Martin Hans

(56) References cited:
- US-A1- 2017 263 739
- US-A1- 2020 266 073

## Description

### TECHNICAL FIELD

This application relates to the field of chip technologies, and in particular, to a chip and an electronic device.

### BACKGROUND

As a core device in an electronic circuit, a power semiconductor component may be used to implement efficient transmission and conversion of electric energy, and implement efficient utilization of electric energy.

The power semiconductor component may be integrated into the power semiconductor chip. To prevent external water vapor and movable ions (for example, sodium) from affecting the power semiconductor component inside the power semiconductor chip, a passivation layer is usually covered on a part of a metal layer which is located in a terminal area of the power semiconductor chip, and the passivation layer is used to block the water vapor.

However, in some scenarios, when a reliability test such as a temperature cycle test (TCT) or a thermal shock test (TS) is performed on a semiconductor component, because thermal expansion coefficients of the metal layer and the passivation layer mismatch, stress is generated between the metal layer and the passivation layer due to mutual extrusion, and excessive stress causes a crack on the passivation layer at a step of the metal layer. Consequently, the water vapor enters an active area of the power semiconductor chip from the crack on the passivation layer, and erodes the power semiconductor component, affecting reliability of the power semiconductor component.

US 2017/263739 discloses: a chip, divided into a main functional area, a transition area, and a protection area, wherein the transition area is located between the main functional area and the protection area; the chip comprises a field oxide, a metal layer, and a passivation layer that are sequentially stacked on a semiconductor substrate, wherein the field oxide and the passivation layer are located in the transition area and the protection area, and the metal layer is located in the main functional area and the transition area; and in the transition area, the field oxide comprises a primary field oxide and at least one secondary field oxide that are disposed at intervals, wherein the secondary field oxide is located on a side of the primary field oxide facing the main functional area, the metal layer extends from the main functional area to a side of the primary field oxide facing away from the semiconductor substrate, and the passivation layer extends from a side of the metal layer facing away from the semiconductor substrate to a side of the metal layer facing away from the main functional area.

### SUMMARY

To resolve the foregoing technical problem, this application provides a chip and an electronic device, to reduce a cracking risk of a passivation layer and improve reliability of the chip. The claimed invention is described in independent product claim 1 and its dependent claims 2-12.

### BRIEF DESCRIPTION OF DRAWINGS

FIG. 1 is a structural block diagram of an electronic device according to an embodiment of this application;
FIG. 2a is a schematic top view of a chip according to conventional technology;
FIG. 2b is an enlarged and schematic sectional view of an area A in FIG. 2a;
FIG. 2c is a schematic structural diagram of a main junction of a junction terminal extension structure;
FIG. 2d is a schematic structural diagram of a main junction of a variation lateral doping structure;
FIG. 3 is a schematic structural diagram of a chip according to conventional technology;
FIG. 4a is a schematic structural diagram of a chip according to an embodiment falling within the scope of the claimed invention;
FIG. 4b is another schematic structural diagram of a chip according to an embodiment falling within the scope of the claimed invention;
FIG. 4c is still another schematic structural diagram of a chip according to an embodiment falling within the scope of the claimed invention;
FIG. 5 is still another schematic structural diagram of a chip according to an embodiment of this application;
FIG. 6 is still another schematic structural diagram of a chip according to an embodiment which does not fall within the scope of the claimed invention;
FIG. 7 is an enlarged diagram of a transition area in FIG. 6, which does not fall within the scope of the claimed invention;
FIG. 8 is still another schematic structural diagram of a chip according to an embodiment of this application;
FIG. 9a is a preparation process diagram of a metal layer according to an embodiment of this application;
FIG. 9b is a preparation process diagram of a metal layer according to an embodiment of this application;
FIG. 10a is a preparation process diagram of a metal layer according to an embodiment of this application;
FIG. 10b is a preparation process diagram of a metal layer according to an embodiment of this application;
FIG. 11 is a preparation process diagram of a metal layer according to an embodiment of this application; and
FIG. 12 is still another schematic structural diagram of a chip according to an embodiment of this application.

Reference numerals:
10: semiconductor substrate; 11: field plate; 12: field oxide; 121: primary field oxide; 122: secondary field oxide; 13: passivation layer; 14: main junction; 21: metal layer; 211: first metal layer; 212: second metal layer; 201: first part; and 202: second part.

### DESCRIPTION OF EMBODIMENTS

To make the objectives, technical solutions, and advantages of this application clearer, the following clearly and completely describes the technical solutions of this application with reference to the accompanying drawings in embodiments of this application. It is clear that the described embodiments are merely a part rather than all of embodiments of this application. All other embodiments obtained by a person of ordinary skill in the art based on embodiments of this application without creative efforts shall fall within the protection scope of this application.

In this specification, embodiments, claims, and accompanying drawings of this application, terms "first", "second", and the like are merely intended for distinguishing and description, and shall not be understood as an indication or implication of relative importance or an indication or implication of an order. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. "Installation", "connection", "being connected to", and the like should be understood in a broad sense, for example, may be a fixed connection, a detachable connection, or an integral connection; or may be a direct connection, an indirect connection through an intermediate medium, or internal communication between two elements. In addition, the terms "include", "have", and any variant thereof are intended to cover non-exclusive inclusion, for example, include a series of steps or units. Methods, systems, products, or devices are not necessarily limited to those steps or units that are literally listed, but may include other steps or units that are not literally listed or that are inherent to such processes, methods, products, or devices. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

An embodiment of this application provides an electronic device. The electronic device may be an electronic device that requires a chip, such as a mobile phone, a computer, a tablet computer, an automobile, or a wearable device. Certainly, the electronic device may alternatively be another device. A specific form of a terminal is not limited in this embodiment of this application. The foregoing chip may be any chip, including but not limited to a power semiconductor chip. For ease of description, unless otherwise specified, the following uses an example in which the chip is a power semiconductor chip for description.

Most of the electric energy generated by hydropower, thermal power, wind power, or a chemical battery cannot be directly applied to an electronic device. More than 75% of the electric energy can be applied to the electronic device only after being converted by a power semiconductor component.

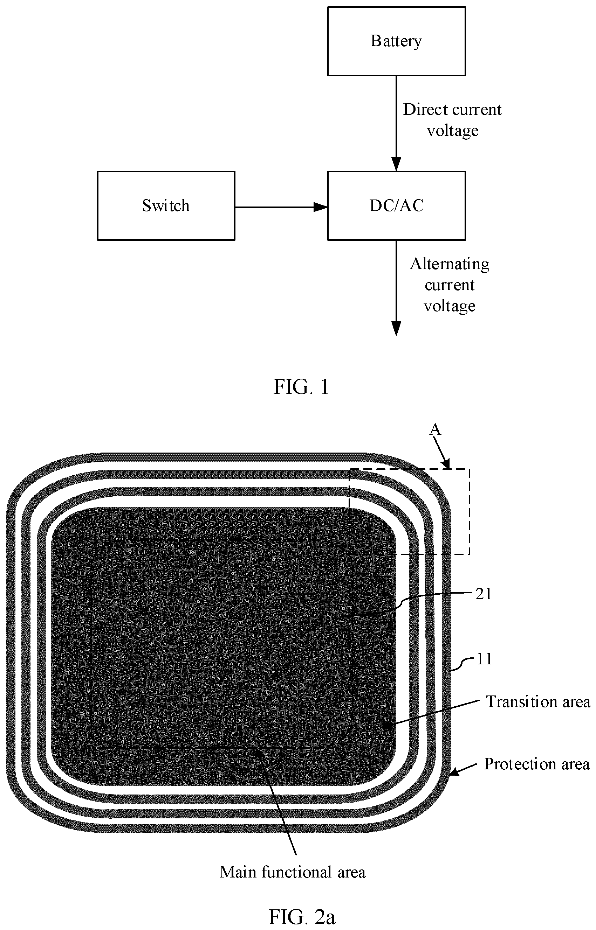

As shown in FIG. 1, an automobile is used as an example. A battery, a switch, and a direct current (DC)/alternating current (AC) device are integrated in the automobile. The battery can provide direct current voltage for the automobile, but the automobile needs to be started under the control of alternating current voltage. Therefore, the power semiconductor component may be used as a switch, so that the DC/AC device is turned on, and the received direct current voltage is converted into the alternating current voltage by using the DC/AC device, so that the automobile is started under the control of the alternating current voltage.

As mentioned above, the passivation layer located in the terminal area is prone to cracks under stress. As a result, the water vapor enters the active area, affecting the reliability of the power semiconductor component.

Specifically, as shown in FIG. 2a, a chip may include a main functional area, a transition area, and a protection area. The transition area and the protection area are located at a periphery of the main functional area, and the transition area is located between the main functional area and the protection area. The main functional area of the chip may correspond to an active area of a power semiconductor chip, and the transition area and the protection area of the chip may correspond to a terminal area of the power semiconductor chip. The terminal area may be of a field limiting ring (FLR) structure, a junction terminal extension (JTE) structure, a variation lateral doping (VLD) structure, various derived composite terminal structures, and the like.

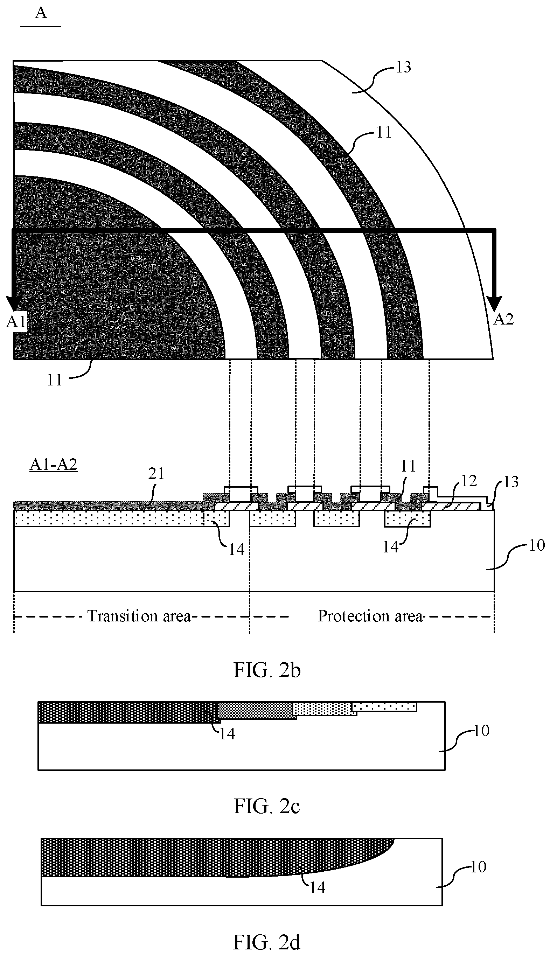

For example, a structure of the transition area and a structure of the protection area are FLR structures. As shown in FIG. 2b, in the main functional area, the power semiconductor chip includes the power semiconductor component disposed on the semiconductor substrate. For example, the power semiconductor component may include a diode, a transistor, a thyristor, and the like disposed on a semiconductor substrate 10. The power semiconductor component includes a metal layer 21, and the metal layer 21 may extend from the main functional area to the transition area. In addition, the power semiconductor chip includes a main junction 14, a field oxide 12, an metal layer 11, and a passivation layer 13 that are sequentially stacked on the semiconductor substrate 10. The main junction 14 may be located in the main functional area, the transition area, and the protection area. The field oxide 12 is located in the transition area and the protection area. The metal layer 11 is located in the protection area. The passivation layer is located in the transition area and the protection area, and may cover a part of the metal layer 21 located in the transition area and cover the metal layer 11, to block water vapor and prevent the water vapor from entering the main functional area. The metal layer 21 and the metal layer 11 that are disposed in the transition area and the protection area may play a role such as modulating electric field distribution.

A pattern of the main junction 14 and some film layers in the power semiconductor component may be prepared by using a same semiconductor process. For example, the pattern of the main junction 14 and an active layer in the power semiconductor component are prepared by using a same semiconductor process, and a pattern of the metal layer 11 and the metal layer 21 in the power semiconductor component are prepared by using a same semiconductor process. In this way, a chip preparation process can be simplified.

In addition, in the transition area, the field oxide 12 is disposed between the metal layer 21 and the metal layer 11 adjacent to the metal layer 21, and the metal layer 21 extends from the main functional area to a side of the field oxide 12 facing away from the semiconductor substrate 10. In the protection area, the field oxide 12 is further disposed between adjacent metal layers 11, and each metal layer 11 extends from a surface of the field oxide 12 facing away from the semiconductor substrate 10 to a surface of a field oxide 12 that is adjacent to the field oxide 12 and that faces away from the semiconductor substrate 10 through an exposed surface on a side of the main junction 14 facing away from the semiconductor substrate 10. Adjacent metal layers 11 are disposed at intervals along a direction from the main functional area to the protection area.

In the transition area, the passivation layer 13 is disposed between adjacent metal layers 21 and the metal layer 11 adjacent to the metal layer 21, and extends from a surface of the metal layer 21 facing away from the semiconductor substrate 10 to a surface of an metal layer 11 that is adjacent to the metal layer 21 and that faces away from the semiconductor substrate 10. In the protection area, the passivation layer 13 is further disposed between adjacent metal layers 11, and each passivation layer 13 extends from a surface of the metal layer 11 facing away from the semiconductor substrate 10 to a surface of an metal layer 11 and that is adjacent to the metal layer 11 and that faces away from the semiconductor substrate 10. Adjacent passivation layers 13 are disposed at intervals along a direction from the main functional area to the protection area.

However, for a chip whose structure of the transition area and structure of the protection area are the JTE structure and the VLD structure, in the terminal area, the power semiconductor chip also includes the main junction 14, the field oxide 12, and the passivation layer 13 that are sequentially stacked on the semiconductor substrate 10. In addition, the metal layer 21 may also extend from the main functional area to the transition area. However, the chip of the JTE structure and the chip of the VLD structure may not include a field plate 11.

For the JTE structure, as shown in FIG. 2c, the protection area may include a plurality of junction terminal extension areas, and a plurality of main junctions 14 are respectively located in the plurality of junction terminal extension areas. In a direction away from the main functional area, doping concentration of the plurality of main junctions 14 gradually decreases, and doping depth gradually becomes shallower.

For the VLD structure, as shown in FIG. 2d, the main junction 14 may extend from the main functional area to the protection area, but along the direction away from the main functional area, the doping concentration of the main junction 14 gradually decreases, and thickness of the main junction 14 also gradually decreases.

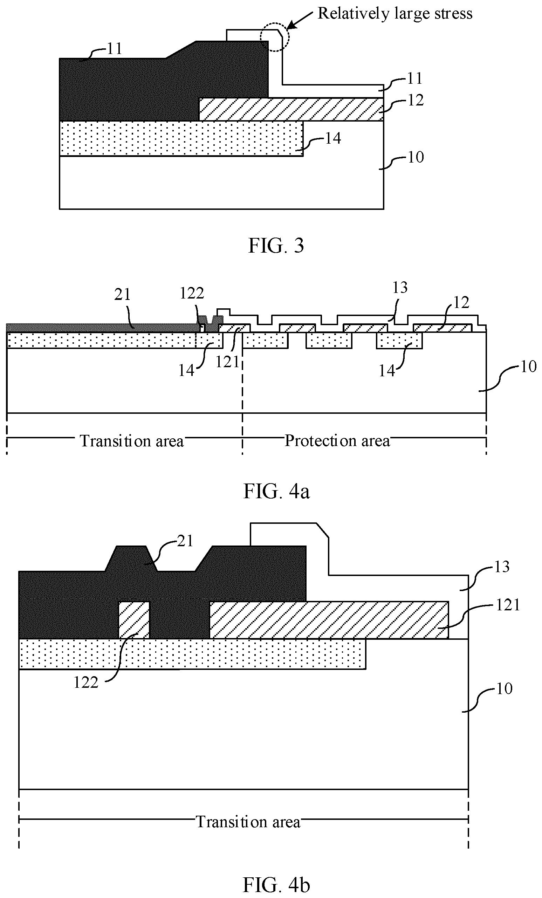

As shown in FIG. 3, in the transition area, because the metal layer 21 has a specific pattern, and thickness of a part of the metal layer 21 located in the transition area is, for example, the same as thickness of a part of the metal layer 21 located in the main functional area, to meet a design requirement of bonding or welding of the power semiconductor component, the metal layer 21 is usually relatively thick, and a thickness range may reach [0.1µm, 7µm]. When a reliability test such as TCT or TS is performed on the semiconductor component, stress on the metal layer 21 with a relatively large size is conducted to the passivation layer 13, the passivation layer 13 may crack because stress at a step of the metal layer 21 which is climbed by the passivation layer 13 is excessively large. Consequently, the water vapor enters the main functional area of the power semiconductor chip from a crack on the passivation layer 13, and erodes the power semiconductor component, affecting the reliability of the power semiconductor component.

In addition, it should be noted that material of the passivation layer 13 is not limited in this embodiment of this application. Optionally, material with relatively good waterproof effect may be selected as the material of the passivation layer 13. For example, the material of the passivation layer 13 may include an inorganic insulation material, and the inorganic insulation material may be silicon nitride (SiN).

For the semiconductor substrate 10, the semiconductor substrate 10 may include a substrate. If material of the substrate includes silicon (Si), the semiconductor substrate 10 may include only the substrate. If the material of the semiconductor substrate 10 includes silicon carbide (SiC), the semiconductor substrate 10 may further include an epitaxial layer disposed between the substrate and a structure such as the field oxide 12.

Based on the foregoing problem, in this application, the structure of the field oxide 12 is improved to reduce the stress conducted by the metal layer 21 to the passivation layer 13 and reduce the cracking risk of the passivation layer 13.

The following describes a specific structure of the chip in detail with reference to the accompanying drawings.

As shown in FIG. 4a and FIG. 4b, for a chip whose structure of the transition area and structure of the protection area are the JTE structure and the VLD structure, the chip includes the field oxide 12, the metal layer 21, and the passivation layer 13 that are sequentially stacked on the semiconductor substrate 10. The field oxide 12 and the passivation layer 13 are located in the transition area and the protection area. The metal layer 21 is located in the main functional area and the transition area. In the transition area, the field oxide 12 includes a primary field oxide 121 and at least one secondary field oxide 122 that are disposed at intervals. The secondary field oxide 122 is located on a side of the primary field oxide 121 facing the main functional area. The metal layer 21 extends from the main functional area to a side of the primary field oxide 121 facing away from the semiconductor substrate 10. The passivation layer 13 extends from a side of the metal layer 21 facing away from the semiconductor substrate 10 to a side of the metal layer 21 facing away from the main functional area.

It should be noted herein that, as shown in FIG. 4a and FIG. 4b, the metal layer 21 extends from the main functional area to the side of the primary field oxide 121 facing away from the semiconductor substrate 10 means that the metal layer 21 that extends from the main functional area to the side of the primary field oxide 121 facing away from the semiconductor substrate 10 is of a continuous structure. In addition, because the secondary field oxide 122 is located on the side of the primary field oxide 121 facing the main functional area, the continuous metal layer 21 not only covers a surface of the primary field oxide 121 facing away from the semiconductor substrate 10, but also covers all surfaces of the secondary field oxide 122 facing away from the semiconductor substrate 10.

In some possible implementations, in this application, the existing field oxide 12 may be divided into the primary field oxide 121 and the at least one secondary field oxide 122; or in this application, the at least one secondary field oxide 122 may be added on the basis of the existing field oxide 12.

In the solution of this application, in the transition area, the existing field oxide 12 is divided into the primary field oxide 121 and the at least one secondary field oxide 122, or the at least one secondary field oxide 122 is added on the basis of the existing primary field oxide 121, and the primary field oxide 121 and the at least one secondary field oxide 122 are disposed at intervals. In this way, the at least one secondary field oxide 122 may provide buffer effect, to prevent stress that extends from the main functional area to a metal layer 21 on the side of the primary field oxide 121 facing away from the semiconductor substrate 10 from being transmitted to the passivation layer 13, thereby effectively reducing stress between a large-sized metal layer 21 and the passivation layer 13, reducing the cracking risk of the passivation layer 13, and preventing the water vapor from entering the main functional area of the chip through a crack on the passivation layer 13, which may affect functions of components in the main functional area.

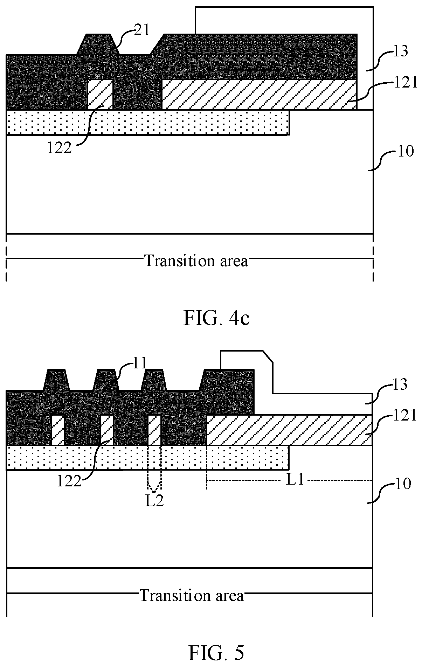

In some possible implementations, as shown in FIG. 4b, to prevent the water vapor from entering the main functional area through the field oxide 121, the passivation layer 13 further extends from the side of the metal layer 21 facing away from the main functional area to a side of the primary field oxide 121 facing away from the main functional area. In this case, as shown in FIG. 4b, the metal layer 21 covers a part of a surface on the side of the primary field oxide 121 facing away from the semiconductor substrate 10; or as shown in FIG. 4c, the metal layer 21 completely covers a surface on the side of the primary field oxide 121 facing away from the semiconductor substrate 10.

As shown in FIG. 4b, in the transition area, the metal layer 21 covers the part of the surface on the side of the primary field oxide 121 facing away from the semiconductor substrate 10. In this way, along a direction from the semiconductor substrate 10 to the metal layer 21, the passivation layer 13 first climbs from the side of the primary field oxide 121 facing away from the main functional area to the side of the primary field oxide 121 facing away from the semiconductor substrate 10; and then climb from the side of the metal layer 21 facing away from the main functional area to the side of the metal layer 21 facing away from the semiconductor substrate 10. Therefore, the passivation layer 13 is prevented from simultaneously climbing at a step of the primary field oxide 121 and a step of the metal layer 21, and a total height of steps that need to be climbed by the passivation layer 13 is increased, so that the cracking risk of the passivation layer 13 may be reduced.

In some possible implementations, as shown in FIG. 4b and FIG. 4c, there may be one secondary field oxide 122; or as shown in FIG. 5, there may be a plurality of secondary field oxides 122. A quantity of the secondary field oxides 122 is related to a size of the secondary field oxide 122, a size of the primary field oxide 121, spacing between the secondary field oxide 122 and the primary field oxide 121, spacing between adjacent secondary field oxides 122, and a size of the chip. This is not limited in this embodiment of this application.

It should be noted herein that when there are a plurality of secondary field oxides 122, and the plurality of secondary field oxides 122 are disposed at intervals.

Optionally, as shown in FIG. 5, there may be three secondary field oxides 122. Along a direction from the main functional area to the protection area, a length range of each secondary field oxide 122 is [0.2µm, 100µm], and a spacing range between adjacent secondary field oxides 122 is [0.2µm, 100µm].

For example, as shown in FIG. 5, a distance L from a side that is closest to the main functional area and that is of the secondary field oxide facing the main functional area to the side of the primary field oxide facing away from the main functional area is 100µm. Along the direction from the main functional area to the protection area, a length L1 of the primary field oxide 121 may be 50µm, and a length L2 of each secondary field oxide 122 may be 10µm, the spacing between the adjacent secondary field oxides 122 and the spacing between the primary field oxide 121 and the secondary field oxide 122 may be 5µm. In this case, there may be three secondary field oxides 122.

In some possible implementations, whether there is one or more secondary field oxides 122, both the primary field oxide 121 and the at least one secondary field oxide 122 that are located in the transition area may be prepared by using the same semiconductor process.

For example, the primary field oxide 121 and the at least one secondary field oxide 122 may be formed by using the following steps: first, a thin film and a first photoresist are sequentially formed on the semiconductor substrate 10. Then, exposure is performed on the first photoresist, and a first photoresist pattern is obtained after development. The first photoresist pattern covers the to-be-formed primary field oxide 121 and the at least one secondary field oxide 122, and exposes an area of the thin film other than the area occupied by the to-be-formed primary field oxide 121 and the at least one secondary field oxide 122. Then, under protection of the first photoresist pattern, the thin film is etched to obtain the primary field oxide 121 and the at least one secondary field oxide 122. The thin film may be, for example, a silicon dioxide (SiO₂) thin film.

Certainly, another process may alternatively be used to form the primary field oxide 121 and the at least one secondary field oxide 122. This is not limited in this embodiment of this application. Provided that a finally obtained structural relationship between the primary field oxide 121 and the at least one secondary field oxide 122 is the same as that described above, a process of forming the primary field oxide 121 and the at least one secondary field oxide 122 falls within the protection scope of this application. In addition, the field oxide 12 located in the protection area and the field oxide 12 located in the transition area may also be prepared by using a same semiconductor process.

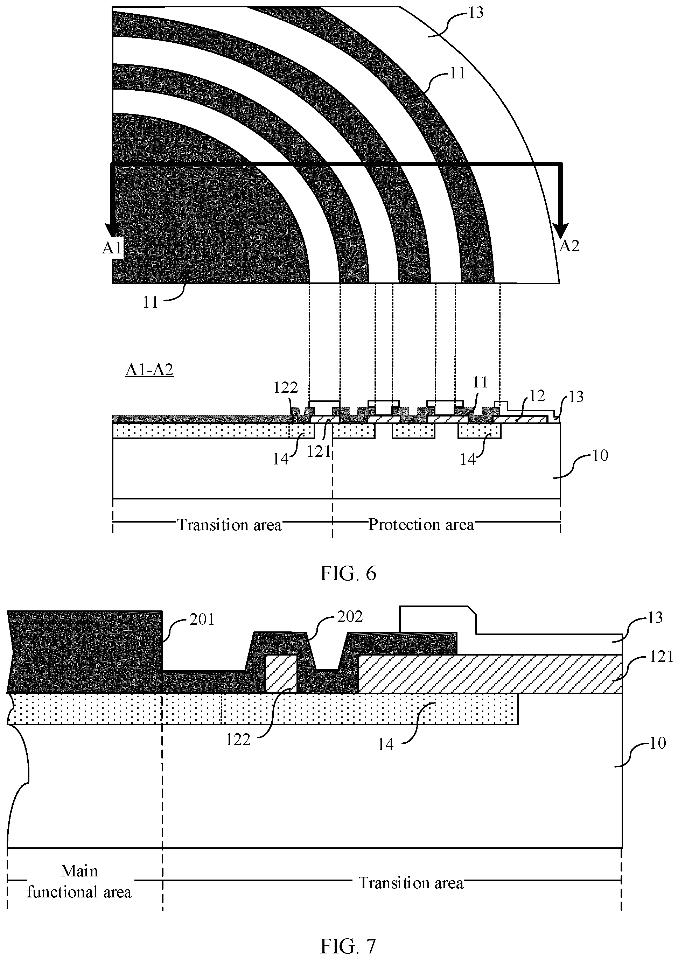

The foregoing embodiment describes the chip whose structure of the transition area and structure of the protection area are the JTE structure and the VLD structure. For the chip whose structure of the transition area and structure of the protection area are the FLR structures, the chip may further include an metal layer 11. As shown in FIG. 6, which does not fall within the scope of the claimed invention, the metal layer 11 is located in the protection area. In the protection area, the metal layer 11 extends from the side of the primary field oxide 121 facing away from the semiconductor substrate 10 to the side of a primary field oxide 121 that is adjacent to the primary field oxide 121 and that faces away from the semiconductor substrate 10. In addition to covering the metal layer 21, the passivation layer 13 further extends from a side of the metal layer 11 facing away from the semiconductor substrate 10 to a side of an metal layer 11 that is adjacent to the metal layer 11 and that faces away from the semiconductor substrate 10. In this way, not only the metal layer 11 can be used to provide an isopotential function, but also the passivation layer 13 can be used to cover the metal layer 11, to prevent the water vapor from entering the main functional area.

As mentioned above, the thickness of the part of the metal layer 21 located in the main functional area is the same as the thickness of the part of the metal layer 21 is located in the transition area. However, to meet a design requirement of the metal layer 21, the metal layer 21 is usually relatively thick. Consequently, the height of the step at the metal layer 21 which needs to be climbed by the passivation layer 13 is relatively high, and under stress, the passivation layer 13 easily cracks at the step.

Based on this, in some embodiments, which do not fall within the scope of the claimed invention but are useful for understanding the invention, as shown in FIG. 7, the metal layer 21 may include a first part 201 and a second part 202. The first part 201 is located in at least the main functional area, and the second part 202 is located in the transition area. Along a direction from the metal layer 21 to the semiconductor substrate 10, thickness of the first part 201 is greater than thickness of the second part 202.

In this application, by reducing the thickness of the second part 202, stress conducted from the first part 201 with a relatively large size to the second part 202 can be reduced, to reduce the stress between the metal layer 21 (or the second part) and the passivation layer 13, reduce the cracking risk of the passivation layer 13, and prevent the water vapor from entering the main functional area of the chip through the crack on the passivation layer 13, which may affect the functions of the components in the main functional area.

In some possible implementations, a thickness range of the first part 201 and a thickness range of the second part 202 are not limited in this embodiment of this application, provided that the second part 202 can provide the isopotential function, and the first part 201 can meet a design requirement of components located in the main functional area.

Optionally, the thickness range of the second part 202 may be [0.1µm, 4µm]. For example, the thickness of the second part 202 may be 0.1µm, 0.6µm, 2µm, or 4µm. The thickness range of the first part 201 may be [0.1µm, 7µm]. For example, the thickness of the metal layer 21 may be 1µm, 2.5µm, 3.2µm, 4µm, 5µm, or 7µm.

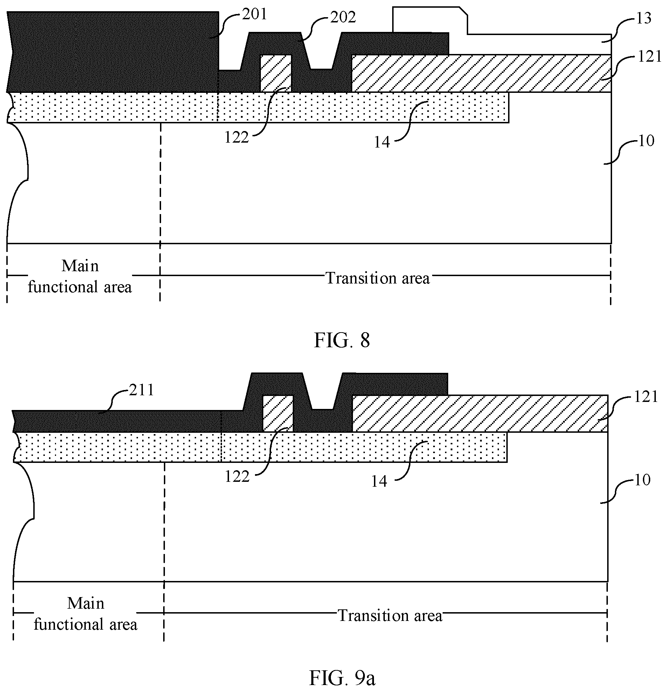

In some possible implementations, as shown in FIG. 8, in addition to being located in the main functional area, the first part 201 may further extend from the main functional area to the transition area. In other words, in addition to a part of the first part 201 being disposed in the main functional area, other parts of the first part 201 may further be disposed in the transition area, to prevent a phenomenon that in a process of preparing components in the main functional area, the first part 201 cannot be in good contact with another component in the main functional area due to inaccurate alignment process which may affect the performance of the components in the main functional area. In addition, by locating the part of the first part 201 located in the transition area on a side of the secondary field oxide 122 facing the main functional area, on the basis that the at least one secondary field oxide 122 is used to buffer the stress, it can be further avoided that relatively large stress is still conducted to the passivation layer 13 after the metal layer 21 with relatively large thickness passes through the at least one secondary field oxide 122.

In some possible implementations, a process of preparing the first part 201 and the second part 202 is not limited in this embodiment of this application. For example, the first part 201 and the second part 202 that are of the metal layer 21 may be prepared in the following several manners.

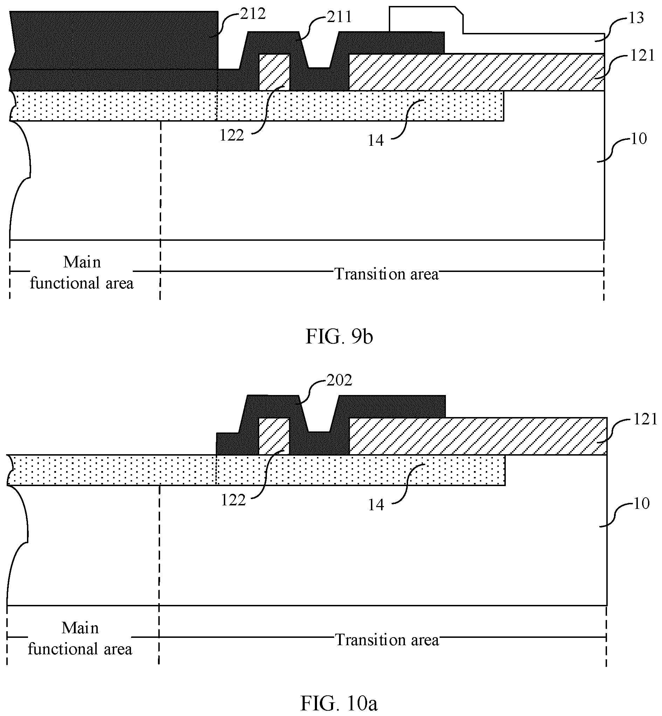

In a first case, as shown in FIG. 9a, a first metal layer 211 is formed on a side of the field oxide 12 facing away from the semiconductor substrate 10 by using a same semiconductor process. Thickness of the first metal layer 211 is the same as thickness of the second part 202, and the first metal layer 211 is located in the main functional area and the transition area. Then, as shown in FIG. 9b, a second metal layer 212 is formed on a side of the first metal layer 211 facing away from the semiconductor substrate 10 by using a photo-lithographic process, and the second metal layer 212 is located in at least the main functional area. In this case, material of the first metal layer 211 may be the same as or different from material of the second metal layer 212.

For an area in which the first metal layer 211 and the second metal layer 212 are disposed in a stacked manner, the first metal layer 211 and the second metal layer 212 may form the first part 201 of the metal layer 21. A thickness range of the first metal layer 211 may be [0.1µm, 4µm], and a thickness range of the second metal layer 212 may be [0.1µm, 4µm], to ensure that a total thickness range of the first part 201 is [0.1µm, 7µm].

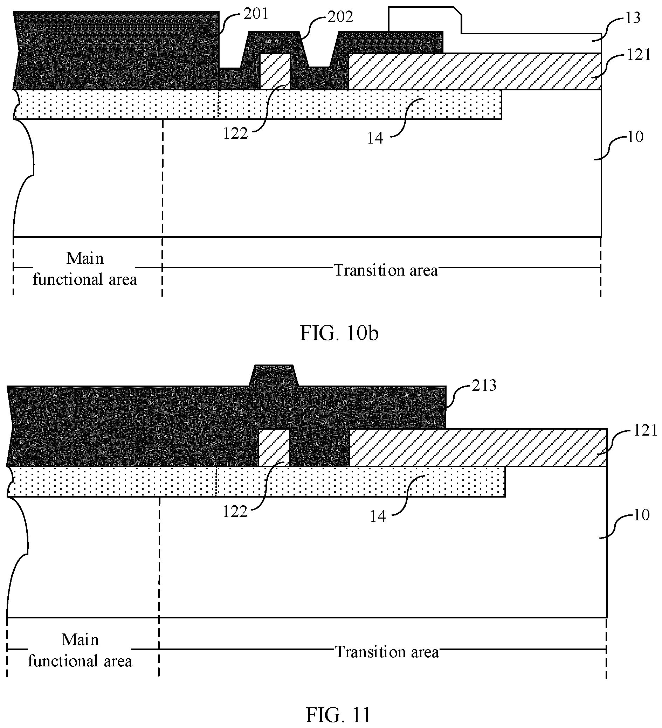

In a second case, as shown in FIG. 10a, the second part 202 is first formed in the transition area by using the photo-lithographic process. Then, as shown in FIG. 10b, the first part 201 is formed in the main functional area (or the main functional area and the transition area) by using the photo-lithographic process. In this case, material of the first metal layer 211 may be the same as or different from material of the second metal layer 212.

Certainly, the first part 201 may be first formed in the main functional area (or the main functional area and the transition area), and then the second part 202 is formed in the transition area. This is not limited in this embodiment of this application.

In a third case, a metal thin film and a second photoresist may be first sequentially formed on a side of the field oxide 12 facing away from the semiconductor substrate 10. Then, half exposure is performed on the second photoresist, and a second photoresist pattern is obtained after development. The second photoresist pattern includes a fully-reserved area, a half-reserved area, and a fully-exposed area. The fully-reserved area corresponds to a to-be-formed metal layer 21, the half-reserved area corresponds to a to-be-formed second part 202, and the fully-exposed area corresponds to another area. Then, as shown in FIG. 11, under protection of the second photoresist pattern, the metal thin film is etched for a first time to obtain a metal pattern 213. Then, exposure is further performed on the second photoresist pattern, and a third photoresist pattern is obtained after the development. The third photoresist pattern corresponds to a to-be-formed first part 201. Then, under protection of the third photoresist pattern, the metal pattern 213 is etched to obtain the first part 201 and the second part 202 that are of the metal layer 21 shown in FIG. 7 or FIG. 8. In this case, material of the first metal layer 211 is the same as material of the second metal layer 212.

Certainly, the first part 201 and the second part 202 that are of the metal layer 21 may be formed by using another process. This is not limited in this embodiment of this application. Provided that a finally obtained structural relationship between the first part 201 and the second part 202 is the same as that described above, a process of forming the first part 201 and the second part 202 that are of the metal layer 21 falls within the protection scope of this application.

In addition, for the chip whose transition area and protection area are of the FLR structures, the metal layer 11 and the first part 201 or the second part 202 of the metal layer 21 may be formed by using a same semiconductor process. To be specific, when the first part 201 is formed, the metal layer 11 may be formed by using the same semiconductor process; or when the second part 202 is formed, the metal layer 11 may be formed by using the same semiconductor process.

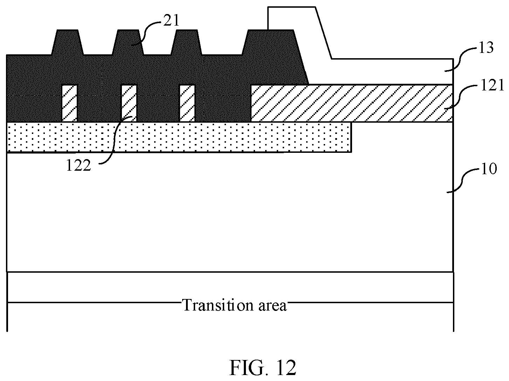

In some embodiments, as shown in FIG. 12, a surface on the side of the metal layer 21 facing away from the main functional area may be a slant surface; and along the direction from the metal layer 21 to the semiconductor substrate 10, the distance between the slant surface and the main functional area gradually increases.

In this application, the surface on the side of the metal layer 21 facing away from the main functional area is disposed as the slant surface, so that when a height of a step which is climbed by the passivation layer 13 remains unchanged, the slant surface can be used to buffer the passivation layer 13, thereby resolving a problem that the passivation layer 13 easily cracks at the step, and preventing the water vapor from entering the active area of the power semiconductor chip from the crack on the passivation layer 13 and eroding the power semiconductor component, which may affect the reliability of the power semiconductor component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip, divided into a main functional area, a transition area, and a protection area, wherein the transition area is located between the main functional area and the protection area;
the chip comprises a field oxide (12), a metal layer (21), and a passivation layer (13) that are sequentially stacked on a semiconductor substrate (10), wherein the field oxide (12) and the passivation layer (13) are located in the transition area and the protection area, and the metal layer (21) is located in the main functional area and the transition area; and
in the transition area, the field oxide (12) comprises a primary field oxide (121) and at least one secondary field oxide (122) that are disposed at intervals, wherein the secondary field oxide (122) is located on a side of the primary field oxide (121) facing the main functional area, the metal layer (21) extends from the main functional area to a side of the primary field oxide (121) facing away from the semiconductor substrate (10), and the passivation layer (13) extends from a side of the metal layer (21) facing away from the semiconductor substrate (10) to a side of the metal layer (21) facing away from the main functional area,
wherein in the transition area, the passivation layer (13) further extends from the side of the metal layer (21) facing away from the main functional area to a side of the primary field oxide (121) facing away from the main functional area; and
the metal layer (21) covers a part of a surface on the side of the primary field oxide (121) facing away from the semiconductor substrate (10), and the passivation layer (13) extends from the side of the metal layer (21) facing away from the semiconductor substrate (10) through the side of the primary field oxide (121) facing away from the semiconductor substrate (10) to the side of the primary field oxide (121) facing away from the main functional area.

2. The chip according to claim 1, wherein there are a plurality of secondary field oxides, and the plurality of secondary field oxides are disposed at intervals.

3. The chip according to claim 2, wherein there are three secondary field oxides, and along a direction from the main functional area to the protection area, a length range of each secondary field oxide is from 0.2µm to 100µm, and a spacing range between adjacent secondary field oxides is from 0.2µm to 100µm.

4. The chip according to any one of claims 1 to 3, wherein the metal layer (21) comprises a first part (201) and a second part (202), the first part (201) is located in at least the main functional area, and the second part (202) is located in the transition area; and
along a direction from the metal layer (21) to the semiconductor substrate (10), thickness of the first part (201) is greater than thickness of the second part (202).

5. The chip according to claim 4, wherein the first part (201) extends from the main functional area to the transition area.

6. The chip according to claim 4 or 5, wherein the metal layer (21) comprises a first metal layer (211) and a second metal layer (212), the first metal layer (211) is located between the semiconductor substrate (10) and the second metal layer (212), and thickness of the first metal layer (211) is the same as the thickness of the second part (202); and
the first metal layer (211) is located in the main functional area and the transition area, and the second metal layer (212) is located in at least the main functional area.

7. The chip according to claim 4 or 5, wherein a thickness range of the first part (201) is from 1µm to 7µm, and a thickness range of the second part (202) is from 0.1µm to 4µm.

8. The chip according to any one of claims 1 to 7, wherein the chip further comprises a third metal layer located in the protection area; and
in the protection area, the third metal layer extends from the side of the primary field oxide (121) facing away from the semiconductor substrate (10) to a side of a further primary field oxide that is adjacent to the primary field oxide (121) and that faces away from the semiconductor substrate (10), and the passivation layer (13) extends from a side of the third metal layer facing away from the semiconductor substrate (10) to a side of a further metal layer that is adjacent to the third metal layer and that faces away from the semiconductor substrate (10).

9. The chip according to claim 8, wherein when the metal layer (21) comprises the first metal layer (211) and the second metal layer (212), a field plate and the first metal layer (211) are at a same layer and of a same material; and
the first metal layer (211) and the second metal layer (212) are at a same layer and of a same material.

10. The chip according to any one of claims 1 to 9, wherein a surface on the side of the metal layer (21) facing away from the main functional area is a slant surface; and
along the direction from the metal layer (21) to the semiconductor substrate (10), the distance between the slant surface and the main functional area gradually increases.

11. The chip according to any one of claims 1 to 10, further comprising a main junction, wherein the main junction extends from the main functional area to the transition area and is in contact with the at least one secondary field oxide (122) and the primary field oxide (121).

12. An electronic device, comprising a circuit card and the chip according to any one of claims 1 to 11, wherein the chip is disposed on the circuit card.

## Patentansprüche

1. Chip, der in einen Hauptfunktionsbereich, einen Übergangsbereich und einen Schutzbereich aufgeteilt ist, wobei sich der Übergangsbereich zwischen dem Hauptfunktionsbereich und dem Schutzbereich befindet;
der Chip ein Feldoxid (12), eine Metallschicht (21) und eine Passivierungsschicht (13) umfasst, die sequenziell auf einem Halbleitersubstrat (10) gestapelt sind, wobei sich das Feldoxid (12) und die Passivierungsschicht (13) in dem Übergangsbereich und dem Schutzbereich befinden und sich die Metallschicht (21) in dem Hauptfunktionsbereich und dem Übergangsbereich befindet; und
in dem Übergangsbereich das Feldoxid (12) ein Primär-Feldoxid (121) und mindestens ein Sekundär-Feldoxid (122) umfasst, die in Intervallen angeordnet sind, wobei sich das Sekundär-Feldoxid (122) auf einer Seite des Primär-Feldoxids (121) befindet, die dem Hauptfunktionsbereich zugewandt ist, sich die Metallschicht (21) von dem Hauptfunktionsbereich zu einer Seite des Primär-Feldoxids (121) erstreckt, die von dem Halbleitersubstrat (10) weggewandt ist, und sich die Passivierungsschicht (13) von einer Seite der Metallschicht (21), die von dem Halbleitersubstrat (10) weggewandt ist, zu einer Seite der Metallschicht (21) erstreckt, die von dem Hauptfunktionsbereich weggewandt ist,
wobei sich in dem Übergangsbereich die Passivierungsschicht (13) ferner von der Seite der Metallschicht (21), die von dem Hauptfunktionsbereich weggewandt ist, zu einer Seite des Primär-Feldoxids (121) erstreckt, die von dem Hauptfunktionsbereich weggewandt ist; und
die Metallschicht (21) einen Teil einer Oberfläche auf der Seite des Primär-Feldoxids (121) abdeckt, die von dem Halbleitersubstrat (10) weggewandt ist, und sich die Passivierungsschicht (13) von der Seite der Metallschicht (21), die von dem Halbleitersubstrat (10) weggewandt ist, durch die Seite des Primär-Feldoxids (121), die von dem Halbleitersubstrat (10) weggewandt ist, zu der Seite des Primär-Feldoxids (121) erstreckt, die von dem Hauptfunktionsbereich weggewandt ist.

2. Chip nach Anspruch 1, wobei es mehrere Sekundär-Feldoxide gibt und die mehreren Sekundär-Feldoxide in Intervallen angeordnet sind.

3. Chip nach Anspruch 2, wobei es drei Sekundär-Feldoxide gibt und entlang einer Richtung von dem Hauptfunktionsbereich zu dem Schutzbereich ein Längenbereich jedes Sekundär-Feldoxids von 0,2 µm bis 100 µm beträgt, und ein Abstandsbereich zwischen benachbarten Sekundär-Feldoxiden 0,2 µm bis 100 µm beträgt.

4. Chip nach einem der Ansprüche 1 bis 3, wobei die Metallschicht (21) einen ersten Teil (201) und einen zweiten Teil (202) umfasst, sich der erste Teil (201) in mindestens dem Hauptfunktionsbereich befindet und sich der zweite Teil (202) in dem Übergangsbereich befindet; und
entlang einer Richtung von der Metallschicht (21) zu dem Halbleitersubstrat (10) Dicke des ersten Teils (201) größer als Dicke des zweiten Teils (202) ist.

5. Chip nach Anspruch 4, wobei sich der erste Teil (201) von dem Hauptfunktionsbereich zu dem Übergangsbereich erstreckt.

6. Chip nach Anspruch 4 oder 5, wobei die Metallschicht (21) eine erste Metallschicht (211) und eine zweite Metallschicht (212) umfasst, sich die erste Metallschicht (211) zwischen dem Halbleitersubstrat (10) und der zweiten Metallschicht (212) befindet und Dicke der ersten Metallschicht (211) gleich der Dicke des zweiten Teils (202) ist; und
sich die erste Metallschicht (211) in dem Hauptfunktionsbereich und dem Übergangsbereich befindet und sich die zweite Metallschicht (212) in mindestens dem Hauptfunktionsbereich befindet.

7. Chip nach Anspruch 4 oder 5, wobei ein Dickebereich des ersten Teils (201) von 1 µm bis 7 µm beträgt und ein Dickebereich des zweiten Teils (202) von 0,1 µm bis 4 µm beträgt.

8. Chip nach einem der Ansprüche 1 bis 7, wobei der Chip ferner eine dritte Metallschicht umfasst, die sich in den Schutzbereich befindet; und
sich in dem Schutzbereich die dritte Metallschicht von der Seite des Primär-Feldoxids (121), die von dem Halbleitersubstrat (10) weggewandt ist, zu einem weiteren Primär-Feldoxid erstreckt, das an das Primär-Feldoxid (121) angrenzt und das von dem Halbleitersubstrat (10) weggewandt ist, und sich die Passivierungsschicht (13) von einer Seite der dritten Metallschicht, die von dem Halbleitersubstrat (10) weggewandt ist, zu einer Seite einer weiteren Metallschicht erstreckt, die an die dritte Metallschicht angrenzt und die von dem Halbleitersubstrat (10) weggewandt ist.

9. Chip nach Anspruch 8, wobei, wenn die Metallschicht (41) die erste Metallschicht (211) und die zweite Metallschicht (212) umfasst, sich eine Feldplatte und die erste Metallschicht (211) auf einer selben Seite befinden und aus einem selben Material bestehen; und
sich die erste Metallschicht (211) und die zweite Metallschicht (212) auf einer selben Schicht befinden und aus einem selben Material bestehen.

10. Chip nach einem der Ansprüche 1 bis 9, wobei eine Oberfläche auf der Seite der Metallschicht (21), die von dem Hauptfunktionsbereich weggewandt ist, eine schräge Oberfläche ist; und
entlang der Richtung von der Metallschicht (21) zu dem Halbleitersubstrat (10) der Abstand zwischen der schrägen Oberfläche und dem Hauptfunktionsbereich allmählich zunimmt.

11. Chip nach einem der Ansprüche 1 bis 10, der ferner einen Hauptübergang umfasst, wobei sich der Hauptübergang von dem Hauptfunktionsbereich zu dem Übergangsbereich erstreckt und sich in Kontakt mit mindestens einem Sekundär-Feldoxid (122) und dem Primär-Feldoxid (121) befindet.

12. Elektronische Vorrichtung, die eine Schaltungskarte und den Chip nach einem der Ansprüche 1 bis 11 umfasst, wobei der Chip auf der Schaltungskarte angeordnet ist.

## Revendications

1. Puce, divisée en une zone fonctionnelle principale, une zone de transition, et une zone de protection, dans laquelle la zone de transition est située entre la zone fonctionnelle principale et la zone de protection ;
la puce comprend un oxyde de champ (12), une couche métallique (21), et une couche de passivation (13) qui sont empilés successivement sur un substrat de semiconducteur (10), dans laquelle l'oxyde de champ (12) et la couche de passivation (13) sont situés dans la zone de transition et la zone de protection, et la couche métallique (21) est située dans la zone fonctionnelle principale et la zone de transition ; et
dans la zone de transition, l'oxyde de champ (12) comprend un oxyde de champ primaire (121) et au moins un oxyde de champ secondaire (122) qui sont disposés à des intervalles, dans laquelle l'oxyde de champ secondaire (122) est situé sur un côté de l'oxyde de champ primaire (121) faisant face à la zone fonctionnelle principale, la couche métallique (21) s'étend de la zone fonctionnelle principale à un côté de l'oxyde de champ primaire (121) orienté à l'opposé du substrat de semiconducteur (10), et la couche de passivation (13) s'étend d'un côté de la couche métallique (21) orienté à l'opposé du substrat de semiconducteur (10) à un côté de la couche métallique (21) orienté à l'opposé de la zone fonctionnelle principale,
dans laquelle, dans la zone de transition, la couche de passivation (13) s'étend en outre du côté de la couche métallique (21) orienté à l'opposé de la zone fonctionnelle principale à un côté de l'oxyde de champ primaire (121) orienté à l'opposé de la zone fonctionnelle principale ; et
la couche métallique (21) recouvre une partie d'une surface sur le côté de l'oxyde de champ primaire (121) orienté à l'opposé du substrat de semiconducteur (10), et la couche de passivation (13) s'étend du côté de la couche métallique (21) orienté à l'opposé du substrat de semiconducteur (10) à travers le côté de l'oxyde de champ primaire (121) orienté à l'opposé du substrat de semiconducteur (10) au côté de l'oxyde de champ primaire (121) orienté à l'opposé de la zone fonctionnelle principale.

2. Puce selon la revendication 1, dans laquelle il y a une pluralité d'oxydes de champ secondaires, et la pluralité d'oxydes de champ secondaires sont disposés à des intervalles.

3. Puce selon la revendication 2, dans laquelle il y a trois oxydes de champ secondaires, et le long d'une direction allant de la zone fonctionnelle principale à la zone de protection, une plage de longueur de chaque oxyde de champ secondaire est de 0,2 µm à 100 µm, et une plage d'espacement entre des oxydes de champ secondaires adjacents est de 0,2 µm à 100 µm.

4. Puce selon l'une quelconque des revendications 1 à 3, dans laquelle la couche métallique (21) comprend une première partie (201) et une seconde partie (202), la première partie (201) est située dans au moins la zone fonctionnelle principale, et la seconde partie (202) est située dans la zone de transition ; et
le long d'une direction allant de la couche métallique (21) au substrat de semiconducteur (10), l'épaisseur de la première partie (201) est supérieure à l'épaisseur de la seconde partie (202).

5. Puce selon la revendication 4, dans laquelle la première partie (201) s'étend de la zone fonctionnelle principale à la zone de transition.

6. Puce selon la revendication 4 ou 5, dans laquelle la couche métallique (21) comprend une première couche métallique (211) et une deuxième couche métallique (212), la première couche métallique (211) est située entre le substrat de semiconducteur (10) et la deuxième couche métallique (212), et l'épaisseur de la première couche métallique (211) est la même que l'épaisseur de la deuxième partie (202) ; et
la première couche métallique (211) est située dans la zone fonctionnelle principale et la zone de transition, et la deuxième couche métallique (212) est située dans au moins la zone fonctionnelle principale.

7. Puce selon la revendication 4 ou 5, dans laquelle une plage d'épaisseur de la première partie (201) est de 1 µm à 7 µm, et une plage d'épaisseur de la seconde partie (202) est de 0,1 µm à 4 µm.

8. Puce selon l'une quelconque des revendications 1 à 7, dans laquelle la puce comprend en outre une troisième couche métallique située dans la zone de protection ; et
dans la zone de protection, la troisième couche métallique s'étend du côté de l'oxyde de champ primaire (121) orienté à l'opposé du substrat de semiconducteur (10) à un côté d'un autre oxyde de champ primaire qui est adjacent à l'oxyde de champ primaire (121) et qui est orienté à l'opposé du substrat de semiconducteur (10), et la couche de passivation (13) s'étend d'un côté de la troisième couche métallique orienté à l'opposé du substrat de semiconducteur (10) à un côté d'une autre couche métallique qui est adjacente à la troisième couche métallique et qui est orientée à l'opposé du substrat de semiconducteur (10).

9. Puce selon la revendication 8, dans laquelle lorsque la couche métallique (21) comprend la première couche métallique (211) et la deuxième couche métallique (212), une plaque de champ et la première couche métallique (211) sont au niveau d'une même couche et constituées d'un même matériau ; et
la première couche métallique (211) et la deuxième couche métallique (212) sont au niveau d'une même couche et constituées d'un même matériau.

10. Puce selon l'une quelconque des revendications 1 à 9, dans laquelle une surface sur le côté de la couche métallique (21) orienté à l'opposé de la zone fonctionnelle principale est une surface inclinée ; et
le long de la direction allant de la couche métallique (21) au substrat de semiconducteur (10), la distance entre la surface inclinée et la zone fonctionnelle principale augmente progressivement.

11. Puce selon l'une quelconque des revendications 1 à 10, comprenant en outre une jonction principale, dans laquelle la jonction principale s'étend de la zone fonctionnelle principale à la zone de transition et est en contact avec l'au moins un oxyde de champ secondaire (122) et l'oxyde de champ primaire (121).

12. Dispositif électronique, comprenant une carte de circuit et la puce selon l'une quelconque des revendications 1 à 11, dans lequel la puce est disposée sur la carte de circuit.
